(19)

**Europäisches Patentamt**
**European Patent Office**
**Office européen des brevets**

(11) **EP 4 592 914 A1**

(12) **EUROPEAN PATENT APPLICATION**

(43) Date of publication:
**30.07.2025 Bulletin 2025/31**

(21) Application number: **24209356.5**

(22) Date of filing: **29.10.2024**

(51) International Patent Classification (IPC):
**G06N 20/00** (2019.01) **G06Q 10/0633** (2023.01)

(52) Cooperative Patent Classification (CPC):
**G06N 20/00; G06Q 10/0633**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **27.11.2023 US 202318519993**

(71) Applicant: **Carl Zeiss SMT GmbH**
**73447 Oberkochen (DE)**

(72) Inventor: **SRIKANTHA, Abhilash**
**73447 Oberkochen (DE)**

(74) Representative: **Pfiz/Gauss Patentanwälte PartmbB**
**Tübinger Strasse 26**
**70178 Stuttgart (DE)**

Remarks:
Claims 16 - 20 are deemed to be abandoned due to non-payment of the claims fees (Rule 45(3) EPC).

(54) **METHODS, SYSTEMS, COMPUTER PROGRAMS AND COMPUTER-READABLE MEDIA FOR AUTOMATICALLY DESIGNING A WORKFLOW TO PERFORM A SEMICONDUCTOR INSPECTION TASK**

(57) The invention relates to a computer implemented method for automatically designing a workflow for semiconductor inspection, the method comprising: receiving input data (12) to be processed by the workflow; receiving a natural language text (14) describing at least a desired output (21) of the workflow; using the natural language text (14) as input to a trained workflow proposal machine learning model (16) that generates one or more workflow proposals (18) each comprising a sequence of action items (40) to generate the desired output (21) when applied to the input data (12); prompting a user to confirm a workflow proposal (18); and applying the confirmed workflow proposal (17) to the input data (12) to perform a semiconductor inspection task (19). The invention also relates to corresponding computer programs, computer-readable media and systems.

Fig.2

EP 4 592 914 A1

## Description

## Field of the Invention

The invention relates to methods and systems for automatically designing a workflow to perform a semiconductor inspection task using a natural language text as input.

## Background of the Invention

In semiconductor inspection, complex software is used for image acquisition (e.g., volumetric reconstructions from cross beam images), image improvement (e.g., removing scan distortions, noise) and image evaluation (e.g., defect detection, defect evaluation, structure measurements). The corresponding software usually provides one or more workflows that can be selected by the user to evaluate the acquired images. However, such workflows can neither be modified to accustom user preferences, nor can they be adapted to other tasks that require a different workflow. Some flexibility can be provided by means of complex interfaces. These, however, require expert knowledge of the user, user training, detailed documentation and a help-desk system. Furthermore, designing new workflows is a time-consuming process for the designer, who needs to obtain a high level of generality to allow for different application scenarios and user preferences.

It is, therefore, an objective of the invention to make software and systems for semiconductor inspection tasks re-usable and adaptable to other tasks. It is also an objective of the invention to improve the customizability, sustainability and applicability of software and systems for semiconductor inspection tasks. It is another objective of the invention to shorten the design cycle and improve the efficiency of the design process of such software and systems. It is another objective of the invention to make software and systems for semiconductor inspection tasks usable and adaptable by non-expert users.

The objectives are achieved by the invention specified in the independent claims. Advantageous embodiments and further developments of the invention are specified in the dependent claims.

## Summary of the invention

Embodiments of the invention concern computer implemented methods, computer-readable media, computer programs and systems for automatically designing a workflow for semiconductor inspection.

An embodiment of the invention involves a computer implemented method for automatically designing a workflow for semiconductor inspection. The method comprises: receiving input data to be processed by the workflow; receiving a natural language text describing at least a desired output of the workflow; using the natural language text as input to a trained workflow proposal machine learning model that generates one or more workflow proposals each comprising a sequence of action items to generate the desired output when applied to the input data; prompting a user to confirm a workflow proposal; and applying the confirmed workflow proposal to the input data to perform a semiconductor inspection task.

A semiconductor inspection task comprises many different applications, e.g., the inspection of photolithography masks and the inspection of wafers. A semiconductor inspection task can comprise defect detection, defect localization, defect segmentation, defect assessment, structure measurements, critical dimension measurements, repair shape generation, etc.

A semiconductor inspection task can be organized as a data-flow and can comprise components such as data input, data preprocessing, data analysis, output postpro-cessing. The data input stage refers to importing (multi-modal) data and relevant meta-data (e.g., pixel size, milling depth range, landing energy, dwell time, metrology blueprint etc.) The data pre-processing stage refers to transforming input data into a predefined format via e.g., image registration, image alignment, conducting data quality checks, fiducial alignment etc. The data analysis extracts information from underlying data e.g., defect detection, defect classification, segmentation, object detection, dimension measurement, instance tracking, 2D/3D morphological analysis etc. The output post-processing steps are e.g., generating plots using the results from data analysis, overlaying results on input images, exporting selected results onto a csv file etc.

The term "workflow" refers to a sequence of action items that is performed in order to carry out a task, e.g., a semiconductor inspection task. The term "action item" refers to a building block of a workflow that performs a subtask. Action items can, for example, comprise: "input data import", "input data alignment", "annotation", "object detection", "contour extraction", "segmentation", "depth estimation", "tracking", "structure measurements", "plotting", "distance transform", "histogram", "average value", etc.

The input data to be processed by the workflow can comprise any kind of data the workflow shall be applied to, for example one or more imaging datasets, time series data, text, etc.

A natural language text comprises a number of written words in any language. Instead of natural language texts, other input methods are conceivable as well. For example, visual sketches of the workflow could be used as a description of the workflow.

Instead of selecting a workflow from a predefined limited set of workflows in a software, the user can indicate the input data to be processed by the workflow and describe the desired output of the workflow using a natural language text. The workflow proposal machine learning model is trained to automatically generate one or more workflow proposals from the natural language text.

The workflow proposals transform the input data to the desired output data. In this way, various workflow proposals can be generated to solve various kinds of tasks according to user preferences. Thus, the software is flexible and widely applicable to various problems. Furthermore, the software is re-usable, since it is not limited to a predefined set of workflows. In addition, no expert knowledge is required from users, no extensive training and no detailed documentation of different interfaces or functionalities. Finally, the design cycle is shortened.

According to an example, the method further provides options to the user to modify the confirmed workflow proposal. In this way, the applicability, sustainability and re-usability of the method is further improved.

In an example, the method further comprises storing the input data and/or the confirmed workflow proposal in one or more databases. In this way, input data and/or confirmed workflow proposals can be used as training data for improving the workflow proposal machine learning model.

In an example, the workflow proposal machine learning model comprises a conditional random field. In this way, the generated workflow proposals can be improved.

In a preferred embodiment, the method comprises collecting meta data values for meta data items describing properties of the input data and/or of workflow proposals and/or of the workflow to be designed. Based on meta data items similarities between different input data and/or workflow proposals and/or workflow proposals and the workflow to be designed can be found. These can, for example, be used to complete missing information in the natural language text, for consistency checks of workflow proposals, as additional input to the workflow proposal machine learning model, etc. In this way, the generated workflow proposals can be improved.

In an example, the meta data items are organized in a hierarchical way. The hierarchy level of the meta data items can, for example, express the level of specificity of the meta data items. Using hierarchically organized meta data items allows for an efficient collection of meta data items and meta data values.

According to an aspect, meta data values for meta data items are collected by prompting a user to indicate meta data values for meta data items for the input data and/or workflow proposals and/or the workflow to be designed. Alternatively or additionally, meta data values for meta data items are collected by applying a trained machine learning model for meta data extraction to the input data and/or workflow proposals and/or the natural language text. A user can be prompted to confirm the automatically generated meta data items and/or meta data values. By using machine learning models for meta data extraction, meta data values for meta data items can be collected quickly, automatically and without requiring additional user effort. By prompting a user, the collected meta data values for meta data items are more reliable, they can contain more exact descriptions and they can contain rare descriptions that have not been learned by the machine learning model for meta data extraction. The collected meta data values for meta data items can comprise meta data values that are collected for a predefined list of meta data items. Alternatively or additionally, the collected meta data values and the meta data items are both obtained by the user or by the machine learning model for meta data extraction.

In an example, one or more meta data items are associated with a similarity relevance value indicating the relevance of the meta data item for the similarity of different input data and/or different workflow proposals and/or workflow proposals and the workflow to be designed. For example, the purpose of a workflow proposal is more relevant to evaluate similarities than the time of generation of the workflow proposal. In this way, relevance weighted similarities can be used to find similarities with a higher accuracy.

In an example, meta data values for meta data items are associated with workflow proposals and with the workflow to be designed, and the workflow proposal machine learning model additionally uses further workflow proposals as input, the further workflow proposals being associated with meta data values that are similar to the meta data values associated with the workflow to be designed. The further workflow proposals can, for example, be used to derive additional information for the workflow to be designed that is not given in the natural language text. Thus, the workflow proposals can be improved.

According to an aspect, options are automatically provided to the user to complete the natural language text during entering the natural language text. In this way, the entering of the natural language text is simplified and can be accomplished more quickly. In addition, during text completion, the user can directly be hinted at important information that should be indicated in the natural language text. Thus, the workflow proposals can be improved.

According to an embodiment of the invention, a computer implemented method for training a workflow proposal machine learning model according to any one of the methods described above comprises: obtaining training data comprising workflows containing sequences of action items and natural language texts describing at least an output of the workflows; modifying parameters of the workflow proposal machine learning model, thereby minimizing an objective function.

According to an aspect of the invention, the training data comprises similarities of action items. These can, for example, be derived from descriptions of action items. The similarities of action items can be used to speed up the training and to improve the workflow proposals.

In an example, rules are derived from the training data, and the validity of sequences of action items is evaluated using the derived rules. These rules can be used during training to improve the workflow proposals and speed up the training process. They can also be used for consistency checks to evaluate the generated workflow proposals, thus improving the results.

In an example, associations between evaluation metrics and action items are derived from the training data. In this way, consistency checks can be carried out and the generated workflow proposals can be improved. In addition, the associations can be used to improve and speed up the training process.

A computer program according to an embodiment of the invention comprises instructions which, when the program is executed by a computer, cause the computer to carry out a method according to any one of the preceding claims.

A computer-readable medium according to an embodiment of the invention, stores a computer program executable by a computing device, the computer program comprising code for executing a method according to any of the methods described above.

A system for automatically designing a workflow for semiconductor inspection according to an embodiment of the invention comprises: one or more processing devices; and one or more machine-readable hardware storage devices comprising instructions that are executable by one or more processing devices to apply a method for automatically designing a workflow for semiconductor inspection according to any of the methods described above.

The invention described by examples and embodiments is not limited to the embodiments and examples but can be implemented by those skilled in the art by various combinations or modifications thereof.

**Brief Description of the Drawings**

Fig. 1 illustrates a flowchart of a computer implemented method for automatically designing a workflow for semiconductor inspection according to an embodiment of the invention;

Fig. 2 illustrates the application of a computer implemented method for automatically designing a workflow for semiconductor inspection according to an embodiment of the invention;

Fig. 3 shows an example workflow proposal that is automatically generated by the workflow proposal machine learning model for a natural language text;

Fig. 4 illustrates an exemplary meta data generation workflow that can be used to obtain meta data items and meta data values;

Fig. 5 illustrates further information that can be used for training the workflow proposal machine learning model;

Fig. 6 illustrates a preferred embodiment of the invention that uses further workflow proposals as additional input to the workflow proposal machine learning model; and

Fig. 7 illustrates a system for automatically designing a workflow for semiconductor inspection according to an embodiment of the invention.

**Detailed Description**

In the following, advantageous exemplary embodiments of the invention are described and schematically shown in the figures. Throughout the figures and the description, same reference numbers are used to describe same features or components. Dashed lines indicate optional features.

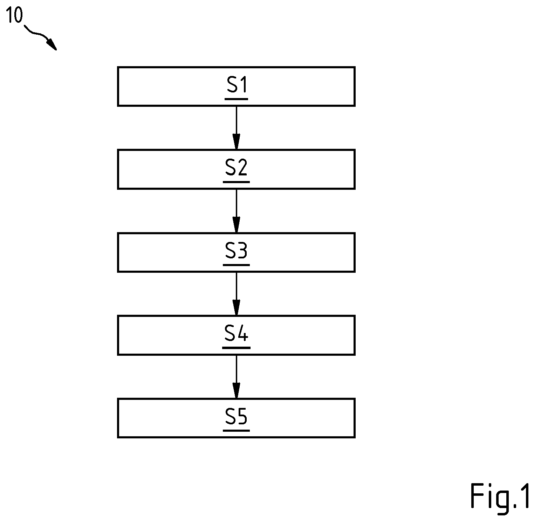

Fig. 1 illustrates a flowchart of a computer implemented method for automatically designing a workflow for semiconductor inspection according to an embodiment of the invention. The method comprises: receiving input data to be processed by the workflow in a step S1; receiving a natural language text describing at least a desired output of the workflow in a step S2; using the natural language text as input to a trained workflow proposal machine learning model that generates one or more workflow proposals each comprising a sequence of action items to generate the desired output when applied to the input data in a step S3; prompting a user to confirm a workflow proposal in a step S4; and applying the confirmed workflow proposal to the input data to perform a semiconductor inspection task in a step S5.

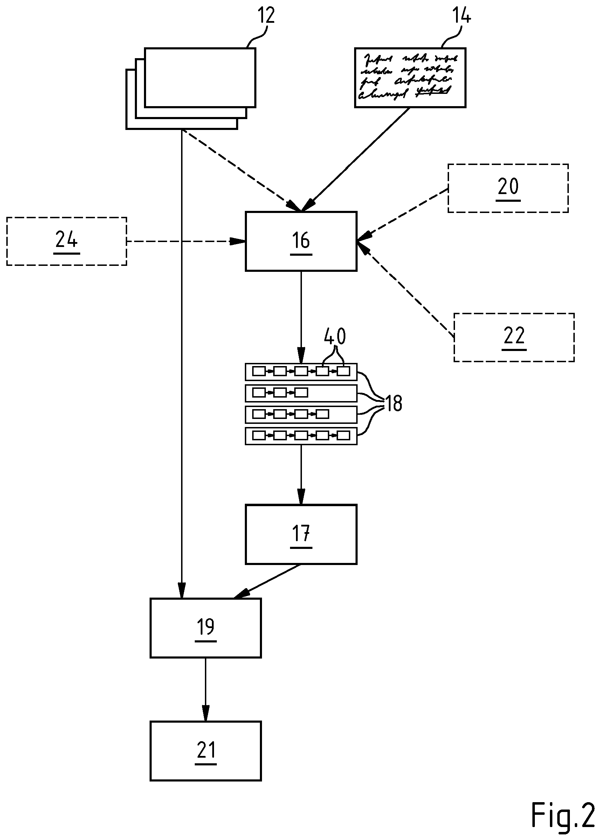

Fig. 2 illustrates an application of the computer implemented method for automatically designing a workflow for semiconductor inspection according to an embodiment of the invention. The workflow proposal machine learning model 16 receives the natural language text 14 as input and generates several workflow proposals 18. The workflow proposal machine learning model 16 can, optionally, receive the input data 12 as additional input. Each workflow comprises a set of action items 40 and generates the desired output 21 when applied to the input data 12. The number of action items 40 in the workflow proposals can differ. The workflow proposal machine learning model 16 can, optionally, use one or more databases 20, 22 containing additional information, e.g., meta information on the workflow proposals and/or the input data, further information 24 about action items, a collection of confirmed workflow proposals, documentation of workflows or action items, etc. The user is prompted to confirm a workflow proposal 18. The confirmed workflow proposal 17 is applied to the input data 12 to perform a semiconductor inspection task 19, thereby generating the desired output 21.

An imaging dataset can comprise one or more images of one or more portions of an object comprising integrated circuit patterns or of the whole object. An object comprising integrated circuit patterns can, for example, be a photolithography mask or a wafer. Various imaging modalities may be used to acquire an imaging dataset. Imaging datasets can comprise single-channel images or multi-channel images, e.g., focus stacks. For instance, it is possible that the imaging dataset includes 2-D images. It is possible to employ a multi beam scanning electron microscope (mSEM). mSEM employs multiple beams to acquire contemporaneously images in multiple fields of view. For instance, a number of not less than 50 beams could be used or even not less than 90 beams. Each beam covers a separate portion of a surface of the object comprising integrated circuit patterns. Thereby, a large imaging dataset is acquired within a short duration of time. Other examples for imaging datasets including 2D images relate to imaging modalities such as optical imaging, phase-contrast imaging, x-ray imaging, etc. It is also possible that the imaging dataset is a volumetric 3-D dataset, which can be processed slice-by-slice or as a three-dimensional volume. Here, a crossbeam imaging device including a focused-ion beam (FIB) source, an atomic force microscope (AFM) or a scanning electron microscope (SEM) could be used. Multimodal imaging datasets may be used, e.g., a combination of x-ray imaging and SEM. The imaging dataset can also comprise aerial images acquired by an aerial imaging system. An aerial image is the radiation intensity distribution at substrate level. It can be used to simulate the radiation intensity distribution generated by a photolithography mask during the photolithography process. The aerial image measurement system can, for example, be equipped with a staring array sensor or a line-scanning sensor or a time-delayed integration (TDI) sensor. The imaging dataset can also be a model dataset, e.g., a CAD dataset or a portion thereof or some other kind of model. The imaging dataset can also be a simulated dataset, e.g., an aerial image generated using a rigorous simulation method such as finite difference time domain (FDTD) or rigorous coupled wave analysis (RWCA), or a fast approximation method such as the thin element approximation (TEA).

The natural language text describing at least a desired output of the workflow can additionally contain specific action items that should appear in the workflow, descriptions of intermediate results of the workflow, user preferences, requirements concerning the order of action items, e.g., that action item X follows action item Y, a description of the input data, a desired annotation type, measurements, etc. The natural language text can also comprise a complete description of the workflow or of parts thereof. Examples for natural language texts are "find defects in input data", "segment defects from input data", "compare input data to database data", "measure average radius of tube structures", "measure critical dimension of structures in input data", "apply workflow X to five splits of Y dataset and report mean and variance of the L2-metric", etc.

The natural language text can contain a description of the input data, e.g., additional information such as the acquisition method (SEM, xray, aerial image, etc.), the quality of the input data (high, low, etc.), properties of the input data (contrast, brightness, grey value or color range, data format, etc.), specific features of interest (regions of interest, defect types to be expected, type of semiconductor structures, structures of interest, etc.), etc.

The natural language text can contain descriptions of annotations to be carried out as a step in the workflow. For example, "annotate center points of all ellipsoidal structures with ellipticity at least 0.5, orientation between 50 and 70° and a pitch of 60nm", "annotate all circular structures with radius 80nm arranged in a hexagonal grid with pitch 160nm that have three inner concentric rings. Annotate each ring as a different class".

In an example, the natural language text can be entered into a prompt by a user, and options are automatically provided to the user to complete the natural language text. Such options can be derived from a database containing previously entered natural language texts and/or previously confirmed workflow proposals including the natural language text, e.g., by using a machine learning model for text completion.

The input data can be used as additional input to the workflow proposal machine learning model. In this way, the generated workflow proposals can be directly adapted to the input data, e.g., to the format of the input data, to the grey value or color range of the input data, to the size of the input data, etc. Furthermore, information not included in the natural language text can be derived from the input data, e.g., the type of input data or the image acquisition method.

In an example, the user can give feedback to evaluate the generated workflow proposals of the workflow proposal machine learning model. The feedback can, for example, comprise a number on a scale indicating the quality of the workflow proposal. The feedback can, for example, indicate "good" or "bad". Feedback information can also be automatically derived from the number of modifications the user applies to a workflow proposal before it is confirmed. The feedback can be used to improve and speed up the training of the workflow proposal machine learning model.

Instead of defining a workflow by a series of action items, which requires expert knowledge, time, user effort and a highly flexible software, the method allows the user to describe the desired output of the workflow for a given input and automatically generates workflow proposals. The user can then confirm one of the proposals and apply the confirmed workflow proposal to the input data to perform a semiconductor inspection task.

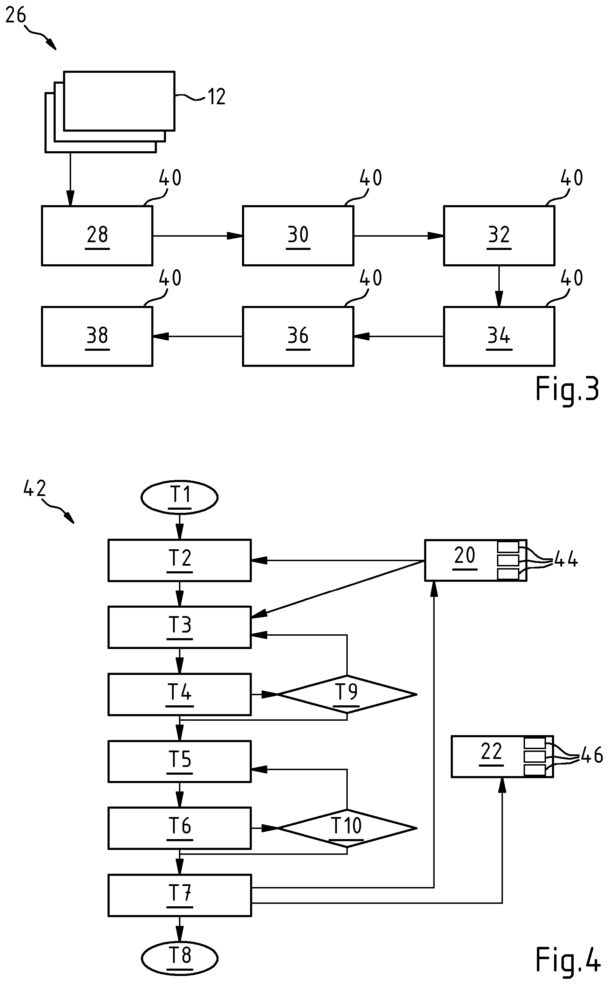

Fig. 3 shows an example workflow proposal 26 that is automatically generated by the workflow proposal machine learning model 16 for the natural language text "Plot distance statistics for distances between tubular structures". The workflow proposal 26 comprises a sequence of action items 40 that sequentially process the input data 12.

The sequence comprises the following action items 40: "import input data" 28, "align input data" 30, "object detection" 32, "contour extraction" 34, "distance computation" 36, "plotting" 38. By directly processing the natural language text given by the user, the workflow generation process is highly flexible, since it can be adapted to all kinds of tasks the user defines. In addition, it is much simpler and can be carried out faster by the user without requiring the help of a designer. Furthermore, it does not require expert knowledge on single action items or workflow design.

The workflow proposals are automatically generated by the trained workflow proposal machine learning model. The training data can, for example, consist of multiple natural language text descriptions of workflows for semiconductor inspection tasks describing at least a desired output of the workflow and the corresponding action-items as implemented by the workflows. The natural language text descriptions can sequentially describe the action-items and, therefore, contiguous portions of the descriptions may correspond to a single action-item. Alternatively, the natural language texts can only describe the desired output of the workflow, or they can describe sections of the workflow in a non-sequential order. The natural language text descriptions can be embedded by numerical representations, e.g., using one-hot- or Word2Vec like embeddings.

According to an embodiment, Hidden Markov Models (HMMs) can be used as workflow proposal machine learning models. They can be trained using natural language text descriptions as inputs and the action-item as hidden states. This model also allows for the inclusion of priors or a grammar on action-item sequences e.g., a pre-processing action-item is less likely to be included after a visualization action-item etc. The training of the HMM can, for example, be carried out using the Baum-Welch algorithm which is iteratively trained to maximize the probability of the correct N-action-item workflow for the corresponding natural language text description. During inference, Viterbi decoding is used to infer the best N-action-item workflow for the corresponding natural language text description using the pre-trained model. HMMs have limitations in input feature embeddings, and the workflow size must be pre-determined. These limitations are addressed in further embodiments.

According to another embodiment, the workflow proposal machine learning model, for example, comprises a conditional random field. Conditional random fields (CRFs) are a class of statistical modeling methods often applied in pattern recognition and machine learning and used for structured prediction. Whereas a classifier predicts a label for a single sample without considering "neighboring" samples, a CRF can take context into account. To do so, the predictions are modelled as a graphical model, which represents the presence of dependencies between the predictions. What kind of graph is used depends on the application. For example, in natural language processing, "linear chain" CRFs are popular, for which each prediction is dependent only on its immediate neighbors.

In another embodiment, transformers can be used for processing the natural language text. Due to attention mechanisms of the transformers that enable modeling long-range dependencies between words of the natural language text, more complex natural language texts can be processed by the workflow proposal machine learning model, e.g., natural language texts with dependencies between different sections or natural language texts that do not sequentially describe the workflow.

According to an embodiment of the invention, the method can further provide options to the user to modify the confirmed workflow proposal. Modifications can be made in different ways, e.g., by natural language text descriptions, by explicitly adding, removing or replacing action items in the confirmed workflow proposal, by using a graphical user interface, by using a chat functionality, wherein the system provides modification options in response to user queries for modifications, etc. A graphical user interface could, for example, display the action items of the workflow proposal to the user in their correct order and offer the user a list of possible modifications when selecting one of the action items, e.g., using a mouse pointer. Possible modifications of an action item can, for example, comprise a list of action items the action item can be exchanged for, e.g., different annotation types. Possible modifications of a workflow proposal include the option to modify the order of action items, to delete and to add action items. The user can also indicate desired modifications via a natural language text. The natural language text could be automatically transformed into modifications to the workflow proposal by a trained machine learning model. The modified workflow proposal can be used as training data to improve the workflow proposal machine learning model.

According to an embodiment of the invention, the method further comprises storing the input data and/or the confirmed workflow proposal in one or more databases. In this way, a database of previously confirmed workflow proposals can be established.

These previously confirmed workflow proposals can be used for training the workflow proposal machine learning model. They can also be used for selecting similar workflow proposals that carry out similar tasks and/or are applied to similar input data as the workflow to be designed. From these similar workflow proposals information can be obtained to complete the workflow to be designed, to have an initial guess for the workflow to be designed or to derive information not indicated in the natural language text, etc.

Such a previous workflow database can also be used for retrieving specific workflow proposals, e.g.,

workflow proposals generated within a specific timespan, workflow proposals applied to specific input data, workflow proposals for input data of a specific data acquisition method, workflow proposals for input data comprising specific structures or structure sizes, workflow proposals for input data exhibiting specific properties, etc. A query for workflow proposals can, for example, comprise "retrieve segmentation workflow proposals trained between 2020 and 2023 on wafer input data acquired using a SEM containing structure sizes between 80 and 120nm and a pitch of 160nm", or "retrieve all workflow proposals that were applied to the X dataset", or "retrieve all input data that was used for a specific semiconductor inspection task", or "retrieve all input data including bounding box annotations" etc.

Previously confirmed workflow proposals can be loaded from the database for reusing them, e.g., as a pre-trained model that is adapted to a similar task by means of re-training on different training data, or as a trained model that is applied to different input data. In addition to the confirmed workflow proposals, the database can also store the input data, the natural language text, catch words from the natural language text, meta information for the confirmed workflow proposal, user feedback for the confirmed workflow proposal, annotations for an input dataset, usage statistics, timestamps, etc. This information can be stored in the same database or in a different database. This information can be used for training of the workflow proposal machine learning model, or during queries of the database, e.g., "retrieve all measurement workflow proposals for aerial images with a positive user feedback". The workflow proposal machine learning model can be improved by retrieving all workflow proposals with negative user feedback and re-training the model.

According to a preferred embodiment, the method comprises collecting meta data values for meta data items describing properties of the input data and/or of workflow proposals and/or of the workflow to be designed. Meta data items for describing properties of workflow proposals or the workflow to be designed comprise, for example, "structure type" (e.g., memory, logic, transistor, periphery), "vendor name" (e.g., companies that manufacture memory or logic chips), "imaging conditions" (e.g., low or high latency, low or high contrast, dwell time, pixel size, landing energy, milling rate), "purpose" (e.g., metrology, classification, detection, segmentation, regression, in particular anomaly or defect detection, fine or coarse metrology, 2D or 3D metrology), "result presentation" (e.g., statistic, plotting, metrics, analysis results, in particular coarse or fine structure statistics, intersection over union metrics, proximities, defect densities, false positive rates, defect source analysis) etc. Meta data items for describing properties of the input data comprise, for example, "quality", "contrast variations", "annotation type", "annotation effort", "size", "acquisition method", "acquisition time", etc. Meta data items offer a way of describing a workflow proposal and/or input data and/or the workflow to be designed in a simple standardizes way, that is easy to store and query. It allows for indexing workflow proposals and/or input data to allow for a simple retrieval of specific workflow proposals and/or input data.

The meta data items can be organized in a hierarchical way. The hierarchy level of the meta data items can express the level of specificity of the meta data items. For example, a hierarchy could comprise the following meta data items: "annotations" on a first level, and "annotation type" and "annotation effort" on a second level. Annotation types comprise, for example, "bounding box", "center point", "contour", "pixelwise", while "annotation effort" can, for example, comprise "high", "intermediate", "low". Another hierarchy could comprise the following meta data items: "Image quality" on a first level, and "latency", "contrast", "brightness", "noise level" on a second level.

In an example, meta data values for meta data items are collected by prompting a user to indicate meta data values for meta data items for the input data and/or workflow proposals and/or the workflow to be designed. The user can be prompted for meta data items and corresponding meta data values. Alternatively, the meta data items can be predefined and the user is only prompted for corresponding meta data values. Alternatively, the user can be prompted to either indicate a meta data item and corresponding meta data value or to indicate a meta data value for one of the predefined meta data items. Predefined meta data items can be arranged in a list or a hierarchy of meta data items. The method can comprise the use of means configured for displaying meta data items (and, possibly, potential meta data values) to the user. Alternatively, the method can comprise the use of means configured for letting the user indicate meta data values for meta data items, e.g., using text or by selecting meta data values for meta data items on a screen.

Alternatively or additionally, meta data values for meta data items are collected by applying a trained machine learning model for meta data extraction to the input data and/or to workflow proposals and/or to the natural language text. The trained machine learning model for meta data extraction can generate meta data items and corresponding meta data values for a given input data and/or a workflow proposal and/or a natural language text. Alternatively, the trained machine learning model for meta data extraction can additionally use a list of meta data items as input and only generate meta data values for the list of meta data items from the input data and/or workflow proposals and/or natural language text.

In an example, meta data values for meta data items are generated automatically by a machine learning model for meta data extraction followed by prompting a user for confirmation according to a user preference. For example, meta data values for meta data items are first generated automatically by a machine learning model for meta data extraction. Then a user is prompted to confirm the generated meta data values for meta data items, to modify the meta data items and/or meta data values or to indicate further meta data items and/or meta data values.

In an example, meta data items are selected from a predefined list of meta data items. According to an aspect, the list of meta data items is extended by automatically adding a new meta data item to the list of meta data items in case an unknown meta data item is indicated multiple times for input data and/or workflow proposals and/or workflows to be designed, e.g., in answers given by one or more users when prompted for meta data values for meta data items. Thus, meta data items that repeatedly occur for describing input data, workflow proposals or the workflow to be designed can be automatically added to the list of meta data items. A user can be prompted for confirmation. Similarly, meta data items can be automatically removed from the list, e.g., if they have not been used for a specified timespan for describing input data, workflow proposals or the workflow to be designed. Meta data items can also be added, deleted or modified by a user. Meta data items can be arranged within a hierarchy by a user or automatically.

In a preferred embodiment, the meta data values are used to find similarities between different input data and/or between different workflow proposals and/or between workflow proposals and the workflow to be designed. For example, for a given natural language text describing at least the desired output of the workflow to be designed, meta data values for meta data items can be derived, e.g., by prompting the user or by automatically deriving them using machine learning methods for meta data extraction. Similar previous workflow proposals can then be retrieved from a database using the similarity of meta data values for meta data items. For example, the k-nearest neighbors method can be used to find the k most similar workflow proposals based on meta data values for meta data items. The similarities can be weighted by a similarity relevance value indicating the relevance of a meta data item for the similarity as described below.

The similar workflow proposals can, for example, be used as additional input to the workflow proposal machine learning model. Such additional inputs can, for example, be used by the workflow proposal machine learning model to gain additional information about the desired workflow that is missing in the natural language text. Alternatively, the similarity of workflow proposals can be derived from the similarity of the input data. For example, workflow proposals for input data with similar meta data values as the meta data values for the given input data can be retrieved and used as additional input to the workflow proposal machine learning model. Meta data values for meta data items for input data can either be obtained by prompting a user, or by automatically deriving them from the input data. To this end, machine learning models can be used. Similar workflow proposals can also be used for consistency checks of the generated workflow proposals.

In an example, one or more meta data items are associated with a similarity relevance value indicating the relevance of the meta data item for the similarity of different input data and/or different workflow proposals and/or workflow proposals and the workflow to be designed. For example, meta data items such as "purpose of workflow", "image acquisition method", "workflow result" or "measurement metric" should be identical in similar workflow proposals and are, thus, assigned a higher similarity relevance value (weight)d than meta data items such as "training time", "acquisition time" or "object size" that can differ in similar workflow proposals. By weighting different meta data items according to their similarity relevance value, workflow proposals and/or input data that are similar in the most important aspects can be retrieved.

Fig. 4 illustrates an exemplary meta data generation workflow 42 that can be used to obtain meta data items 44 and corresponding meta data values 46. After starting the meta data generation workflow in a step T1, a questionnaire is generated or selected from a meta data item database 20 containing meta data items 44 and questionnaires in a step T2. The questionnaire can comprise meta data items that are important for identifying the workflow proposal, e.g., the purpose of the workflow proposal, the type of input data, the results of the workflow proposal, the presence of annotations, etc. In a step T3, upon availability, a sub-questionnaire can be retrieved from the meta data item database 20 that contains more detailed questions on meta data items, e.g., the image acquisition type or the type of annotation. In a step T4 the user response is collected. In a step T9, the existence of a follow-up questionnaire is checked. In case a follow-up questionnaire exists, the process is repeated. Otherwise, in a step T5, sub-questions from meta data values are formulated. For example, the k-nearest neighbor method can be used to retrieve similar workflow proposals and input data. For example, if the purpose of the workflow to be designed differs from the k-nearest neighbor workflow proposals the user is questioned for a descriptive explanation. This dynamic way of formulating questions can provide insights into workflow generation and consistency and can be used to update the meta data item database 20. In a step T6, user responses are collected. In a step T10, the existence of follow-up questions is checked and in case a follow-up question exists the process is repeated. Finally, in a step T7 the meta data item database 20 and the meta data value database 22 are updated based on the user responses. Then the process ends in a step T8.

The meta data item database 20 contains various meta data items 44 describing categories applicable to workflow proposals and/or input data, e.g., in the form of graphs or trees or hierarchies containing meta data items 44 in the form of nodes. The meta data item database 20 serves for collecting meta data items 44 and meta data values 46 from the user for any dataset. It is dynamic as nodes can be added/deleted/combined based on previous user responses. The hierarchy of the nodes can also be modified based on user responses. The meta data item database 20 aims at creating a homogenized description of each workflow proposal and input data such that similarities and differences between various workflow proposals and input data can be automatically analyzed.

The meta data value database 22 contains specific workflow proposals and input data together with corresponding meta data values 46 for meta data items 44 in the meta data item database 20. It can also contain text responses. Trends in the text responses can be automatically analyzed to update the meta data item database 20. E.g., if the user consistently comments for a meta data item "input data quality" the term "motion blur", the term "motion blur" is automatically considered as a new meta data item 44 in the meta data item database 20. Techniques like topic modeling and unsupervised clustering can be used for clustering text responses and updating the meta data item database 20.

A computer implemented method for training a workflow proposal machine learning model according to any one of the embodiments described above comprises: obtaining training data comprising workflow proposals containing sequences of action items and natural language texts describing at least an output of the workflows; modifying parameters of the workflow proposal machine learning model, thereby minimizing an objective function.

For example, in case the workflow proposal machine learning model is an HMM, optimization can be carried out as described in the following.

A hidden Markov model describes the joint probability of a collection of "hidden" and observed discrete random variables. It relies on the assumption that the i-th hidden variable given the $(i-1)$-th hidden variable is independent of previous hidden variables, and the current observation variables depend only on the current hidden state. The Baum-Welch algorithm uses the well-known EM algorithm to find the maximum likelihood estimate of the parameters of a hidden Markov model given a set of observed feature vectors.

Let $X_t$ be a discrete hidden random variable that can take on N possible values. Assuming that $P(X_t|X_{t-1})$ is independent of time leads to the definition of the time-independent stochastic transition matrix

$$A = \left(a_{ij}\right) = P(X_t = j|X_{t-1} = i).$$

The initial state distribution for t = 1 is given by

$$\pi_i = \mathrm{P}(X_1 = i).$$

The observation variables $Y_t$ can take one of K possible values. Assuming that the observation given the "hidden" state is time independent, the probability of a certain observation $y_i$ at time t for state $X_t = j$ is given by

$$b_j(y_i) = P(Y_t = y_i|X_t = j).$$

Taking into account all the possible values of $Y_t$ and $X_t$, the $N \times K$ matrix

$$B = \left(b_j(y_i)\right)$$

is obtained, where $b_j$ belongs to all possible states and $y_i$ belongs to all possible observations.

An observation sequence is given by $Y = (Y_1 = y_1, Y_2 = y_2,.., Y_T = y_T)$. Thus, a hidden Markov chain can be described as

$$\theta = (A, B, \pi).$$

The Baum-Welch algorithm finds a local maximum for

$$\theta^* = \mathrm{argmax}_\theta P(Y|\theta).$$

Thus, the HMM parameters $\theta^*$ maximize the probability of the observation.

In an example, the training data comprises further information 24, e.g., descriptions of action items, documentation of workflows or action items, rules about preceding or following action items or sequences of action items, about orders of action items, about a cooccurrence of action items in the same workflow, about a similarity of action items, about associations between action items and evaluation metrics, about exchangeable action items, etc. All kinds of further information can be included in the training data to improve or simplify the workflow proposal machine learning model. The action items and corresponding further information can be stored in a database.

The training data can, for example, comprise similarities of action items. These can, for example, be derived from descriptions of action items. For example, different annotation types are similar, whereas "segmentation" and "object detection" are dissimilar due to their differing purpose. Thus, action items with a high similarity can be easily exchanged in a workflow proposal, whereas dissimilar action items should not be exchanged in a workflow proposal.

The action items can be organized in a tree structure such that the selection of a higher level action item automatically requires a selection of an action item in the level below. For example, an action item "annotation" could be a higher level action item, and specific annotation type action items such as "bounding box annotation", "center point annotation", "pixelwise annotation", "contour annotation" could be action items on the next lower level. Thus, the selection of an "annotation" action item is automatically followed by a selection of the annotation type action item. This structure can, for example, be imposed by means of pairwise probabilities in the optimization process, e.g., the actions-item pairs that should not appear in a sequence can have probability $P(X_t|X_{t-1}) = 0$.

According to an example, rules are derived from the training data, and the validity of sequences of action items is evaluated using the derived rules. The training data comprises (mostly) valid workflow proposals. Thus, information about valid sequences of action items can be derived from the training data. For example, a "load images" action item must precede any further image processing item, whereas a "measure distance" action item can only follow an "object detection" or "segmentation" action item. To generate such rules, statistics can be used that indicate the probability of an action item following or preceding another action item.

According to an example, associations between evaluation metrics and action items are derived from the training data. For example, workflow proposals comprising a "segmentation" action item can be used for measuring critical distances using a CD metrology evaluation metric, whereas workflow proposals comprising a "defect detection" action item can be used for deriving defect statistics using a defect evaluation metric, e.g., number of defects, type of defects, defect density, etc.

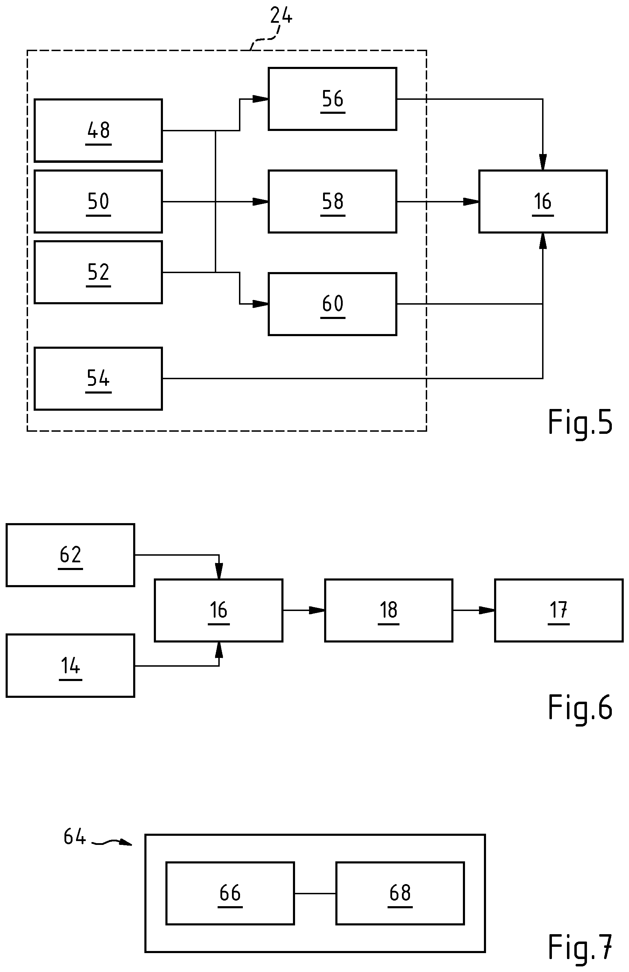

Fig. 5 illustrates further information 24 that can be used for training the workflow proposal machine learning model 16. The further information 24 comprises, for example, code functionalities 48, i.e., all functionalities the program provides for defining workflow proposals and action items, e.g., "load images", "denoise images", "align images", "perform bounding box annotation", "perform pixelwise annotation", "perform bounding box annotation", "train segmentation model", "train object detection model", "extract size", "extract diameter", "evaluate true positive rate", "evaluate false positive rate", "evaluate root-mean-squared-error", "plot metric", etc.). The further information 24 can also comprise documentations 50 provided by the code developers, e.g., textual descriptions of each functionality, module or action item. The further information 24 can also comprise previous workflow proposals 52. These can, for example, be used for consistency checks or for completing missing information or meta data values that are not given in the natural language text. The further information 24 can also comprise text descriptions 54 provided by the user, e.g., natural language text descriptions provided for previous workflow proposals or as answers to questions generated from the meta data item database or the meta data value database. From this further information, similarities 56 of different functionalities or action items can be derived. For example, a "pixelwise annotation" action item is similar to a "bounding box" annotation action item, whereas a "segmentation" action item and an "object detection" action item are dissimilar. Further, this information can be used to assess the validity of sequences of action items. In addition, rules 58 defining permissible orders of action items or functional grammars can be derived. Furthermore, evaluation metrics 60 can be associated with action items. For example, "segmentation" action items can be associated with "critical dimension metrology evaluation metrics", whereas "defect detection" action items can be associated with "defect statistics evaluation metrics". Some or all of this additional information 24 can be used as additional training data for training the workflow proposal machine learning model 16.

Fig. 6 illustrates a preferred embodiment of the invention that uses further workflow proposals 62 as additional input to the workflow proposal machine learning model 16. The further workflow proposals 62 can, for example, be obtained using the k-nearest neighbor method for querying workflow proposals with similar meta data values. Here, similarity relevance values can be taken into account to weight meta data values according to their relevance for the workflow proposal similarity. Other methods can also be used to find similar workflow proposals, e.g., other clustering methods. The trained workflow proposal machine learning model 16 generates one or more workflow proposals 18, and the user confirms one of these proposals. The confirmed workflow proposal is subsequently applied to the input data.

A system 64 for automatically designing a workflow for semiconductor inspection according to an embodiment of the invention illustrated in Fig. 7 comprises: one or more processing devices 66; one or more machine-readable hardware storage devices 68 comprising instructions that are executable by one or more processing devices 66 to apply a method for automatically designing a workflow for semiconductor inspection according to any one of the embodiments, aspects or examples described above. The one or more processing devices 66 can, for example, be implemented as a CPU, GPU or TPU.

Reference throughout this specification to "an embodiment" or "an example" or "an aspect" means that a particular feature, structure or characteristic described in connection with the embodiment, example or aspect is included in at least one embodiment, example or aspect. Thus, appearances of the phrases "according to an embodiment", "according to an example" or "according to an aspect" in various places throughout this specification are not necessarily all referring to the same embodiment, example or aspect, but may. Furthermore, the particular features or characteristics may be combined in any suitable manner, as would be apparent to one of ordinary skill in the art from this disclosure, in one or more embodiments.

Furthermore, while some embodiments, examples or aspects described herein include some but not other features included in other embodiments, examples or aspects combinations of features of different embodiments, examples or aspects are meant to be within the scope of the claims, and form different embodiments, as would be understood by those skilled in the art.

In summary, the invention relates to a computer implemented method for automatically designing a workflow for semiconductor inspection, the method comprising: receiving input data 12 to be processed by the workflow; receiving a natural language text 14 describing at least a desired output 21 of the workflow; using the natural language text 14 as input to a trained workflow proposal machine learning model 16 that generates one or more workflow proposals 18 each comprising a sequence of action items 40 to generate the desired output 21 when applied to the input data 12; prompting a user to confirm a workflow proposal 18; and applying the confirmed workflow proposal 17 to the input data 12 to perform a semiconductor inspection task 19. The invention also relates to corresponding computer programs, computer-readable media and systems.

Reference number list

| 10 | Computer implemented method |
| 12 | Input data |
| 14 | Natural language text |
| 16 | Workflow proposal machine learning model |
| 17 | Confirmed workflow proposal |
| 18 | Workflow proposals |
| 19 | Semiconductor inspection task |
| 20 | Meta data item database |
| 21 | Output |
| 22 | Meta data value database |
| 24 | Further information |
| 26 | Workflow proposal |
| 28 | Import data |
| 30 | Align data |
| 32 | Object detection |
| 34 | Contour extraction |
| 36 | Distance computation |
| 38 | Plotting |
| 40 | Action item |
| 42 | Meta data generation workflow |
| 44 | Meta data item |
| 46 | Meta data value |
| 48 | Code functionalities |
| 50 | Documentation |
| 52 | Workflow proposal |
| 54 | Text descriptions |
| 56 | Similarity |
| 58 | Rules |
| 60 | Evaluation metrics |
| 62 | Further workflow proposal |
| 64 | System |
| 66 | Processing device |
| 68 | Hardware storage device |

**Claims**

1. Computer implemented method (10) for automatically designing a workflow for semiconductor inspection, the method comprising:

 a. Receiving input data (12) to be processed by the workflow;

 b. Receiving a natural language text (14) describing at least a desired output (21) of the workflow;

 c. Using the natural language text (14) as input to a trained workflow proposal machine learning model (16) that generates one or more workflow proposals (18) each comprising a sequence of action items (40) to generate the desired output (21) when applied to the input data (12);

 d. Prompting a user to confirm a workflow proposal (18); and

 e. Applying the confirmed workflow proposal (17) to the input data (12) to perform a semiconductor inspection task (19).

2. The method of claim 1, further providing options to the user to modify the confirmed workflow proposal (17).

3. The method of any one of the preceding claims, further comprising storing the input data (12) and/or the confirmed workflow proposal (17) in one or more databases.

4. The method of any one of the preceding claims, wherein the workflow proposal machine learning model (16) comprises a conditional random field.

5. The method of any one of the preceding claims, further comprising collecting meta data values (46) for meta data items (44) describing properties of the input data (12) and/or of workflow proposals (18) and/or of the workflow to be designed.

6. The method of claim 5, wherein the meta data items (44) are organized in a hierarchical way.

7. The method of claim 5 or 6, wherein meta data values (46) for meta data items (44) are collected by prompting a user to indicate meta data values (46) for meta data items (44) for the input data (12) and/or workflow proposals (18) and/or the workflow to be designed.

8. The method of any one of claims 5 to 7, wherein meta data values (46) for meta data items (44) are collected by applying a trained machine learning model for meta data extraction to the input data (12) and/or to workflow proposals (18) and/or to the natural language text (14) describing at least the desired output (21) of the workflow to be designed.

9. The method of any one of claims 5 to 8, wherein meta data items (44) are selected from a predefined list of meta data items (44), and wherein a new meta data item (44) is automatically added to the list of meta data items (44) in case the meta data item (44) is indicated multiple times for the input data (12) and/or workflow proposals (18) and/or the workflow to be designed.

10. The method of any one of claims 5 to 9, wherein the meta data values (46) are used to find similarities between different input data (12) and/or between different workflow proposals (18) and/or between workflow proposals (18) and the workflow to be designed.

11. The method of any one of claims 5 to 10, wherein one or more meta data items (44) are associated with a similarity relevance value indicating the relevance of the meta data item (44) for the similarity of different input data (12) and/or different workflow proposals (18) and/or workflow proposals (18) and the workflow to be designed.

12. The method of any one of claims 5 to 11, wherein meta data values (46) for meta data items (44) are associated with workflow proposals (18) and with the workflow to be designed, and wherein the workflow proposal machine learning model (16) additionally uses further workflow proposals (18) as input, the further workflow proposals (18) being associated with meta data values (46) that are similar to the meta data values (46) associated with the workflow to be designed.

13. The method of any one of the preceding claims, wherein options are automatically provided to the user to complete the natural language text during entering the natural language text.

14. Computer implemented method for training a workflow proposal machine learning model (16) according to any one of the preceding claims, the method comprising:

   a. Obtaining training data comprising workflows containing sequences of action items (40) and natural language texts (14) describing at least an output (21) of the workflows;
   b. Modifying parameters of the workflow proposal machine learning model (16), thereby minimizing an objective function.

15. The method of claim 14, wherein the training data comprises similarities (56) of action items (40).

16. The method of claim 14 or 15, wherein rules (58) are derived from the training data, and wherein the validity of sequences of action items (40) is evaluated using the derived rules (40).

17. The method of any one of claims 14 to 16, wherein associations between evaluation metrics (60) and action items (40) are derived from the training data.

18. A computer program comprising instructions which, when the program is executed by a computer, cause the computer to carry out a method according to any one of the preceding claims.

19. A computer-readable medium, on which a computer program executable by a computing device is stored, the computer program comprising code for executing a method according to any one of the preceding method claims.

20. A system (64) for automatically designing a workflow for semiconductor inspection, the system comprising:

   a. One or more processing devices (66);
   b. One or more machine-readable hardware storage devices (68) comprising instructions that are executable by one or more processing devices (66) to apply a method (10) for automatically designing a workflow for semiconductor inspection according to any one of claims 1 to 13.

10

| S1 |
|---|

| S2 |
|---|

| S3 |
|---|

| S4 |
|---|

| S5 |
|---|

Fig.1

Fig.2

Fig.3

Fig.4

24

Fig.5

Fig.6

64

Fig.7

Europäisches
Patentamt

European
Patent Office

Office européen
des brevets

## EUROPEAN SEARCH REPORT

**Application Number**

EP 24 20 9356

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2021/201037 A1 (TANG QIAOCHU [US] ET AL) 1 July 2021 (2021-07-01)<br>* paragraph [0012]; figure 5 *<br>* paragraph [0034] - paragraph [0035] *<br>* paragraph [0038] *<br>* paragraph [0048] *<br>* paragraph [0057] *<br>* paragraph [0066] *<br>* paragraph [0157] - paragraph [0160] *<br>- - - - - | 1-15 | INV.<br>G06N20/00<br>G06Q10/0633 |
| A | US 2021/073026 A1 (MYERS CLAYTON [US] ET AL) 11 March 2021 (2021-03-11)<br>* paragraph [0049] - paragraph [0088]; figures 1a,1b *<br>- - - - - | 1-15 | |
| | | | TECHNICAL FIELDS SEARCHED (IPC) |
| | | | G06N<br>G06Q |

The present search report has been drawn up for all claims

| Place of search | Date of completion of the search | Examiner |
|---|---|---|
| Munich | 24 June 2025 | Koblitz, Birger |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 24 20 9356

This annex lists the patent family members relating to the patent documents cited in the above-mentioned European search report.
The members are as contained in the European Patent Office EDP file on
The European Patent Office is in no way liable for these particulars which are merely given for the purpose of information.

24-06-2025

| Patent document cited in search report | Publication date | Patent family member(s) | Publication date |
|---|---|---|---|
| US 2021201037 A1 | 01-07-2021 | US 10607084 B1<br>US 10949672 B1<br>US 2021201037 A1 | 31-03-2020<br>16-03-2021<br>01-07-2021 |
| US 2021073026 A1 | 11-03-2021 | NONE | |

EPO FORM P0459

For more details about this annex : see Official Journal of the European Patent Office, No. 12/82